# EUROPÄISCHE PATENTSCHRIFT

(11) **EP 2 160 773 B1**
(45) Veröffentlichungstag und Bekanntmachung des Hinweises auf die Patenterteilung: **07.11.2018**
(21) Anmeldenummer: 08773275.6
(22) Anmeldetag: 23.06.2008
(51) Int. Cl.: H01L 33/40, H01L 33/44, H01L 33/46

(54) **OPTOELEKTRONISCHER HALBLEITERCHIP**
OPTOELECTRONIC SEMICONDUCTOR CHIP
PUCE SEMI-CONDUCTRICE OPTOÉLECTRONIQUE

(30) Priorität: 26.06.2007 DE 102007029391
(43) Veröffentlichungstag der Anmeldung: 10.03.2010
(73) Patentinhaber: OSRAM Opto Semiconductors GmbH, 93055 Regensburg (DE)
(72) Erfinder: GRÖTSCH, Stefan, 93077 Lengfeld - Bad Abbach (DE); LINDER, Norbert, 93138 Lappersdorf (DE)
(74) Vertreter: Epping - Hermann - Fischer
(86) Internationale Anmeldenummer: PCT/DE2008/001050
(87) Internationale Veröffentlichungsnummer: WO 2009/000257

(56) Entgegenhaltungen:
- EP-A- 1 403 689
- WO-A-02/09243
- WO-A-2006/035388
- WO-A1-2004/112157
- JP-A- S5 740 986
- JP-A- H06 310 757
- JP-A- 2006 041 133
- US-A1- 2004 150 997
- US-A1- 2006 081 869

## Beschreibung

Es wird ein optoelektronischer Halbleiterchip angegeben.

Die Druckschriften WO 02/13281 A1 sowie EP 0 905 797 A2 beschreiben optoelektronische Halbleiterchips sowie Verfahren zu deren Herstellung.

Die Druckschrift JP 2006-041133 A beschreibt ein optoelektronisches Bauteil mit reflektierenden Schichten, welche verhindern, dass Kontaktschichten unterhalb einer aktiven Schicht emittiertes Licht absorbieren.

Die Druckschrift WO 2004/112157 A1 beschreibt einen optoelektronischen Halbleiterchip mit einer Kontaktmetallisierung und einer Stromverteilungsmetallisierung, die auf eine Strahlungsdurchtrittsfläche aufgebracht sind.

Eine zu lösende Aufgabe besteht darin, einen optoelektronischen Halbleiterchip anzugeben, der besonders effizient betrieben werden kann.

Gemäß zumindest einer Ausführungsform umfasst der optoelektronische Halbleiterchip einen Halbleiterkörper mit einer Strahlungsdurchtrittsfläche. Die Strahlungsdurchtrittsfläche ist zum Beispiel durch einen Teil der Oberfläche des Halbleiterkörpers gebildet. Durch die Strahlungsdurchtrittsfläche kann im Halbleiterchip erzeugte elektromagnetische Strahlung den Halbleiterkörper verlassen. Darüber hinaus ist es auch möglich, dass durch die Strahlungsdurchtrittsfläche elektromagnetische Strahlung von außerhalb in den Halbleiterkörper eingekoppelt wird.

Gemäß zumindest einer Ausführungsform umfasst der optoelektronische Halbleiterchip ferner eine

Kontaktmetallisierung. Die Kontaktmetallisierung ist zum Beispiel auf der Strahlungsdurchtrittsfläche des optoelektronischen Halbleiterchips angeordnet. Das heißt, die Kontaktmetallisierung ist dann auf die Strahlungsdurchtrittsfläche des optoelektronischen Halbleiterchips aufgebracht und bedeckt diese stellenweise oder zumindest stellenweise. Mittels der Kontaktmetallisierung kann der optoelektronische Halbleiterchip beispielsweise n- oder p-seitig elektrisch kontaktiert werden. Ein elektrischer Strom zum Betreiben des Chips wird dann mittels der Kontaktmetallisierung in den optoelektronischen Halbleiterchip eingeprägt.

Gemäß der Erfindung ist auf die der Strahlungsdurchtrittsfläche abgewandte Oberfläche der Kontaktmetallisierung eine erste reflektierende Schichtenfolge aufgebracht. Das heißt, die Kontaktmetallisierung ist zumindest stellenweise von der ersten reflektierenden Schichtenfolge bedeckt.

Die reflektierende Schichtenfolge umfasst zumindest eine Schicht. Die reflektierende Schichtenfolge kann aber auch mehrere Schichten umfassen. Die reflektierende Schichtenfolge zeichnet sich dadurch aus, dass sie - zumindest für elektromagnetische Strahlung eines bestimmten Wellenlängenbereichs - eine höhere Reflektivität als die Kontaktmetallisierung aufweist. Das heißt, elektromagnetische Strahlung zumindest eines bestimmten Wellenlängenbereichs wird von der ersten reflektierenden Schichtenfolge besser reflektiert, als dies bei einem Auftreffen dieser elektromagnetischen Strahlung auf die Kontaktmetallisierung der Fall wäre. Beispielsweise weist die erste reflektierende Schichtenfolge für im optoelektronischen Halbleiterchip erzeugte elektromagnetische Strahlung eine, verglichen mit der Kontaktmetallisierung, erhöhte Reflektivität auf.

Gemäß der Erfindung umfasst der optoelektronische Halbleiterchip eine Strahlungsdurchtrittsfläche, eine Kontaktmetallisierung, die auf die Strahlungsdurchtrittsfläche aufgebracht ist, und eine erste reflektierende Schichtenfolge, die auf die der Strahlungsdurchtrittsfläche abgewandten Oberfläche der Kontaktmetallisierung aufgebracht ist, wobei die reflektierende Schichtenfolge zur Reflexion von zur Kontaktmetallisierung zurückreflektierter elektromagnetischer Strahlung vorgesehen ist.

Einem hier beschriebenen optoelektronischen Halbleiterchip liegen dabei unter anderem die folgenden Überlegungen zugrunde: Es hat sich gezeigt, dass beispielsweise bei der Verwendung von Leuchtdiodenchips in optischen Systemen, in denen Licht auf den Leuchtdiodenchip - das heißt zum Beispiel auf die Strahlungsdurchtrittsfläche - zurückreflektiert wird, ein bedeutsamer Verlustmechanismus darin liegt, dass die Kontaktmetallisierung des optoelektronischen Halbleiterchips eine geringe Reflektivität aufweist und die zurückreflektierte Strahlung absorbiert. Das heißt im Halbleiterchip erzeugte elektromagnetische Strahlung wird beispielsweise an einem optischen Element, das dem Halbleiterchip nachgeordnet ist, in Richtung des Halbleiterchips zurückreflektiert. Ein Teil dieser Strahlung kann dabei auf die Kontaktmetallisierung treffen und wird von dieser absorbiert. Diese absorbierte Strahlung geht beispielsweise einem Photonenrecycling im Halbleiterchip verloren.

Mittels der ersten reflektierenden Schichtenfolge, die auf dieser Kontaktmetallisierung angeordnet ist, ist es möglich, die Reflektivität der Kontaktstelle, die sich aus Kontaktmetallisierung mit auf die Kontaktmetallisierung aufgebrachter erster reflektierender Schichtenfolge zusammensetzt, zu erhöhen. Auf diese Weise geht die auf den Leuchtdiodenchip zurückreflektierte elektromagnetische Strahlung nicht verloren, sondern kann nach Reflexion an der ersten reflektierenden Schichtenfolge beispielsweise in das optische System zurückreflektiert werden. Die reflektierende Schichtenfolge weist dazu vorzugsweise eine Reflektivität von wenigstens 90% für im Halbleiterchip erzeugte elektromagnetische Strahlung auf.

Bei der Kontaktmetallisierung handelt es sich zum Beispiel um ein Bondpad, das zur Drahtkontaktierung des Halbleiterchips vorgesehen ist.

Gemäß zumindest einer Ausführungsform des optoelektronischen Halbleiterchips umfasst die erste reflektierende Schichtenfolge zumindest ein Metall. Bei dem Metall kann es sich beispielsweise um Aluminium oder Silber oder um eine Legierung aus diesen Metallen handeln. Ferner ist es möglich, dass die reflektierende Schichtenfolge mehrere Schichten umfasst, die jeweils aus Aluminium und/oder Silber gebildet sind oder Aluminium und/oder Silber enthalten. Die Kontaktmetallisierung selbst, auf welche die erste reflektierende Schichtenfolge aufgebracht ist, kann beispielsweise aus Gold bestehen oder Gold enthalten.

Gemäß zumindest einer Ausführungsform des optoelektronischen Halbleiterchips umfasst die erste reflektierende Schichtenfolge zumindest eine Schicht, die ein dielektrisches Material enthält. Diese Schicht kann beispielsweise auf die der Strahlungsdurchtrittsfläche abgewandten Oberfläche der zweiten reflektierenden Schichtenfolge aufgebracht sein und eine Passivierung für eine reflektierende Metallschicht bilden.

Es ist aber auch möglich, dass die erste reflektierende Schichtenfolge mehrere Schichten desselben oder unterschiedlicher dielektrischer Materialien enthält. Beispielsweise kann die erste reflektierende Schichtenfolge dann aus einer Abfolge erster dielektrischer Schichten mit einem niedrigeren Brechungsindex bestehen, wobei zwischen zwei Schichten mit niedrigem Brechungsindex jeweils wenigstens eine zweite dielektrische Schicht mit einem größeren Brechungsindex angeordnet ist. Die sich abwechselnden dielektrischen Schichten mit unterschiedlichen Brechungsindizes können dann zum Beispiel einen Bragg- oder Bragg-artigen Spiegel bilden.

Gemäß der Erfindung ist zumindest eine Stromverteilungsbahn auf die Strahlungsdurchtrittsfläche des optoelektronischen Halbleiterchips aufgebracht. Die Stromverteilungsbahn ist dabei elektrisch leitend mit der Kontaktmetallisierung verbunden. Die Stromverteilungsbahn ist vorgesehen, mittels der Kontaktmetallisierung eingeprägten elektromagnetischen Strom über die Strahlungsdurchtrittsfläche zu verteilen. Auf diese Weise kann erreicht werden, dass der elektrische Strom möglichst gleichmäßig in eine aktive Zone des optoelektronischen Halbleiterchips eingeprägt wird. Auf diese Weise kann erreicht werden, dass elektromagnetische Strahlung möglichst gleichmäßig in der aktiven Zone des optoelektronischen Halbleiterchips erzeugt werden kann. Dabei kann der optoelektronische Halbleiterchip eine Vielzahl von Stromverteilungsbahnen umfassen, die mit der Kontaktmetallisierung elektrisch leitend verbunden sind und den Strom über die Strahlungsdurchtrittsfläche verteilen.

Gemäß der Erfindung umfasst die Stromverteilungsbahn eine Stromverteilungsmetallisierung, welche auf die Strahlungsdurchtrittsfläche des optoelektronischen Halbleiterchips aufgebracht ist. Die Stromverteilungsmetallisierung kann dabei aus demselben Material wie die Kontaktmetallisierung gebildet sein und wird beispielsweise im selben Herstellungsschritt wie die Kontaktmetallisierung auf die Strahlungsdurchtrittsfläche des Halbleiterchips aufgebracht. Die Stromverteilungsmetallisierung enthält oder besteht dabei zum Beispiel aus zumindest einem der folgenden Materialien: Gold, transparentes leitfähiges Oxid (TCO) wie ITO (Indium Tin Oxide). Die Stromverteilungsbahn umfasst ferner eine zweite reflektierende Schichtenfolge, die auf die der Strahlungsdurchtrittsfläche abgewandten Oberfläche der Stromverteilungsmetallisierung aufgebracht ist, wobei die zweite reflektierende Schichtenfolge zur Reflektion von zur Stromverteilungsmetallisierung zurückreflektierter elektromagnetischer Strahlung vorgesehen ist.

Gemäß zumindest einer Ausführungsform des optoelektronischen Halbleiterchips umfasst die zweite reflektierende Schichtenfolge zumindest eine Schicht, die ein Metall enthält. Bei dem Metall handelt es sich beispielsweise um Aluminium, Silber oder eine Legierung aus den beiden Metallen. Beispielsweise kann die zweite reflektierende Schichtenfolge mehrere Schichten umfassen, die aus Aluminium und/oder Silber bestehen oder Aluminium und/oder Silber enthalten.

Gemäß zumindest einer Ausführungsform des optoelektronischen Halbleiterchips umfasst die zweite reflektierende Schichtenfolge zumindest eine Schicht, die ein dielektrisches Material enthält. Diese Schicht kann beispielsweise auf die der Strahlungsdurchtrittsfläche abgewandten Oberfläche der zweiten reflektierenden Schichtenfolge aufgebracht sein und eine Passivierung für eine reflektierende Metallschicht bilden. Ferner ist es möglich, dass die zweite reflektierende Schichtenfolge mehrere dielektrische Schichten umfasst, wobei zum Beispiel zueinander benachbarte Schichten unterschiedliche Brechungsindizes aufweisen können, sodass die zweite reflektierende Schichtenfolge einen Bragg-artigen oder einen Bragg-Spiegel bildet.

Gemäß zumindest einer Ausführungsform unterscheidet sich die zweite reflektierende Schichtenfolge in ihrer Zusammensetzung von der ersten reflektierenden Schichtenfolge. Dies kann zum Beispiel dadurch erreicht sein, dass die zweite reflektierende Schichtenfolge dielektrische Schichten umfasst, wobei die erste reflektierende Schichtenfolge nur metallische Schichten umfasst. Auf diese Weise ist es besonders einfach möglich, dass der Chip nach der Fertigstellung der ersten und zweiten reflektierenden Schichtenfolge mittels eines Kontaktdrahtes an der Kontaktstelle elektrisch kontaktiert werden kann, da diese dann nicht von dielektrischen Schichten bedeckt ist.

Alternativ ist es jedoch auch möglich, dass die erste und die zweite reflektierende Schichtenfolge identisch aufgebaut sind und beide Schichtenfolgen zumindest eine dielektrische Schicht umfassen.. Beispielsweise kann dann mittels Ätzen oder einer Maskentechnik eine leitende Verbindung zwischen einem Kontaktdraht und der Kontaktmetallisierung erzeugt werden. Es wird weiter ein optoelektronisches Halbleiterbauelement angegeben. Gemäß zumindest einer Ausführungsform des optoelektronischen Halbleiterbauelements umfasst das Bauelement einen optoelektronischen Halbleiterchip gemäß zumindest einer der weiter oben beschriebenen Ausführungsbeispiele. Darüber hinaus umfasst das optoelektronische Halbleiterbauelement ein dem optoelektronischen Halbleiterchip in einer Abstrahlrichtung nachgeordnetes optisches Filterelement, welches geeignet ist, einen ersten Strahlungsanteil mit einer ersten Strahlungseigenschaft zu transmittieren und einen zweiten Strahlungsanteil mit einer zweiten, von der ersten verschiedenen, Strahlungseigenschaft zu reflektieren.

Das optische Filterelement ist dem optoelektronischen Halbleiterchip dabei derart nachgeordnet, dass zumindest ein Teil - vorzugsweise ein Großteil - der im Betrieb vom optoelektronischen Halbleiterchip emittierten elektromagnetischen Strahlung zum optischen Filterelement gelangt und dort transmittiert oder reflektiert wird.

Der vom optischen Filterelement nicht transmittierte, reflektierte Strahlungsanteil trifft auf die Strahlungsdurchtrittsfläche des optoelektronischen Halbleiterchips auf. Dort wird die Strahlung entweder wieder in den optoelektronischen Chip eingekoppelt oder an der Strahlungsdurchtrittsfläche zum optischen Filterelement hin zurückreflektiert oder an der ersten oder zweiten reflektierenden Schichtenfolge, die auf der Kontaktmetallisierung beziehungsweise auf der Stromverteilungsmetallisierung aufgebracht ist, zum optischen Filterelement zurückreflektiert. Die in den optoelektronischen Halbleiterchip durch die Strahlungsdurchtrittsfläche hindurch eingekoppelte elektromagnetische Strahlung kann vom Chip reflektiert oder aber absorbiert und reemittiert werden. Die elektromagnetische Strahlung wird in diesem Fall also photonenrecycelt.

Insgesamt erweist sich ein optoelektronischer Halbleiterchip, bei dem die Reflektivität der Kontaktstelle beziehungsweise der Stromverteilungsbahnen mittels erster und zweiter reflektierender Schichtenfolgen erhöht ist, in einem optoelektronischen Bauelement mit nachgeordnetem optischen Filterelement als besonders vorteilhaft, da auf die Kontaktstelle beziehungsweise die Stromverteilungsbahnen aufgebrachte erste und zweite reflektierende Schichtenfolgen eine Absorption der auftreffenden Strahlung dort unwahrscheinlicher machen oder gänzlich verhindern.

Auf diese Weise ist die Effizienz des optoelektronischen Bauelements gegenüber optoelektronischen Bauelementen mit Halbleiterchips, die keine reflektierenden Schichtenfolgen aufweisen, erhöht.

Vorzugsweise ist die erste Strahlungseigenschaft komplementär zur zweiten Strahlungseigenschaft. Weiterhin kann unter der Strahlungseigenschaft die Richtung, die Polarisation oder die Wellenlänge der Strahlung verstanden werden. Im Sinne des hier beschriebenen optoelektronischen Halbleiterbauelements liegt eine erste Richtung von elektromagnetischer Strahlung innerhalb eines ersten Raumwinkelbereichs, während eine zweite Richtung elektromagnetischer Strahlung in einem zum ersten Raumwinkelbereich komplementären Raumwinkelbereich liegt. Ferner kann eine erste Polarisation einer parallelen Polarisation und eine zweite Polarisation einer senkrechten Polarisation entsprechen. Schließlich kann eine zweite, zur ersten komplementären Wellenlänge eine von der ersten Wellenlänge verschiedene Wellenlänge sein, wobei in diesem Fall komplementär nicht notwendigerweise im engen Sinn der Farbenlehre zu verstehen ist.

Gemäß zumindest einer Ausführungsform des optoelektronischen Halbleiterbauelements umfasst das optische Filterelement ein dichroitisches Filter, das elektromagnetische Strahlung einer ersten Wellenlänge oder eines ersten Wellenlängenbereichs transmittiert und elektromagnetische Strahlung einer zweiten Wellenlänge oder eines zweiten Wellenlängenbereichs reflektiert.

Gemäß zumindest einer Ausführungsform des optoelektronischen Halbleiterbauelements umfasst das optische Filterelement ein Polarisationsfilter, das elektromagnetische Strahlung einer ersten Polarisation transmittiert und elektromagnetische Strahlung einer zweiten Polarisation reflektiert.

Gemäß zumindest einer Ausführungsform des optoelektronischen Halbleiterbauelements umfasst das optische Filterelement ein Winkelfilter, das elektromagnetische Strahlung einer ersten Richtung transmittiert, während die elektromagnetische Strahlung einer zweiten Richtung reflektiert wird.

Gemäß zumindest einer Ausführungsform des optoelektronischen Halbleiterbauelements umfasst das optische Filterelement ein Lumineszenzkonversionsmaterial, welches aus zumindest einem Teil der vom Halbleiterchip emittierten elektromagnetischen Strahlung Wellenlängen konvertierte Strahlung mit Wellenlängen erzeugt, die von den Wellenlängen, der vom Halbleiterchip erzeugten Strahlung, verschieden sind.

Im Folgenden wird der hier beschriebene optoelektronische Halbleiterchip sowie das hier beschriebene optoelektronische Halbleiterbauelement anhand von Ausführungsbeispielen und den dazugehörigen Figuren näher erläutert.
- Figur 1A: zeigt eine schematische Draufsicht auf einen optoelektronischen Halbleiterchip gemäß einem ersten und einem zweiten Ausführungsbeispiel.
- Figur 1B: zeigt eine schematische Schnittdarstellung eines optoelektronischen Halbleiterchips gemäß dem ersten Ausführungsbeispiel.
- Figur 1C: zeigt eine schematische Schnittdarstellung eines optoelektronischen Halbleiterchips gemäß dem zweiten Ausführungsbeispiel.
- Figur 2A: zeigt eine schematische Draufsicht auf einen optoelektronischen Halbleiterchip gemäß einem dritten und einem vierten Ausführungsbeispiel.
- Figur 2B: zeigt eine schematische Schnittdarstellung eines optoelektronischen Halbleiterchips gemäß dem dritten Ausführungsbeispiel.
- Figur 2C: zeigt eine schematische Schnittdarstellung eines optoelektronischen Halbleiterchips gemäß dem vierten Ausführungsbeispiel.
- Figur 3: zeigt eine schematische Schnittdarstellung eines optoelektronischen Halbleiterbauelements gemäß einem ersten Ausführungsbeispiel.
- Figur 4: zeigt eine schematische Schnittdarstellung eines optoelektronischen Halbleiterbauelements gemäß einem zweiten Ausführungsbeispiel.
- Figur 5: zeigt eine schematische Schnittdarstellung eines optoelektronischen Halbleiterbauelements gemäß einem dritten Ausführungsbeispiel.
- Figur 6: zeigt eine schematische Schnittdarstellung eines optoelektronischen Halbleiterbauelements gemäß einem vierten Ausführungsbeispiel.

In den Ausführungsbeispielen und Figuren sind gleiche oder gleich wirkende Bestandteile jeweils mit den gleichen Bezugszeichen versehen. Die dargestellten Elemente sind nicht als maßstabsgetreu anzusehen, vielmehr können einzelne Elemente zum besseren Verständnis übertrieben groß dargestellt sein.

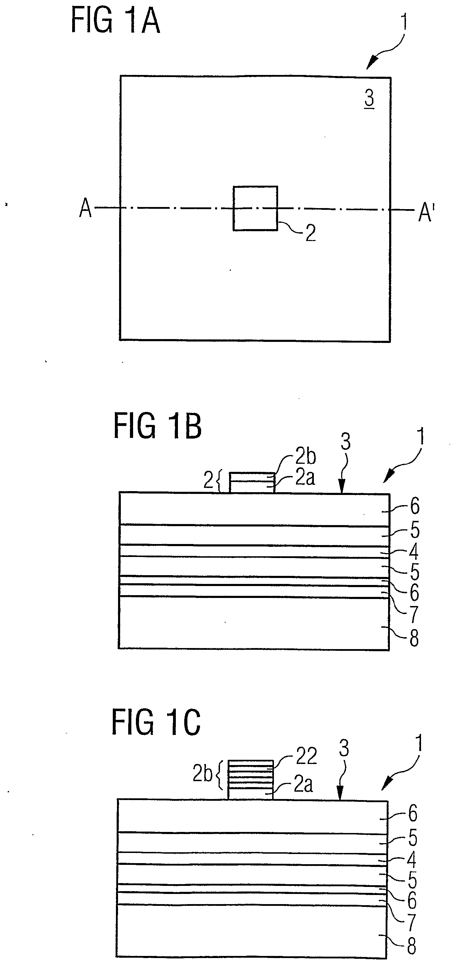

Die Figur 1A zeigt eine schematische Draufsicht auf einen optoelektronischen Halbleiterchip 1 einem ersten und einem zweiten Ausführungsbeispiel. Die Figur 1B zeigt eine Schnittdarstellung entlang der Linie AA' gemäß dem ersten Ausführungsbeispiel. Die Figur 1C zeigt eine Schnittdarstellung entlang der Linie AA' gemäß dem zweiten Ausführungsbeispiel.

Gemäß dem ersten Ausführungsbeispiel umfasst der optoelektronische Halbleiterchip einen Träger 8. Bei dem Träger 8 kann es sich zum Beispiel um ein Aufwachssubstrat handeln, auf das Halbleiterschichten des optoelektronischen Halbleiterchips epitaktisch abgeschieden sind. Es ist aber auch möglich, dass es sich bei dem Träger 8 um einen Träger handelt, der auf die dem ursprünglichen Aufwachssubstrat abgewandte Oberfläche des Halbleiterchips aufgebracht ist. Das Aufwachssubstrat ist dann gedünnt oder ganz entfernt. In diesem Fall kann es sich beim Halbleiterchip 1 insbesondere um einen so genannten Dünnfilm-Halbleiterchip handeln. Leuchtdiodenchips in Dünnfilmbauweise sind beispielsweise in den Druckschriften WO 02/13281 A1 sowie EP 0 905 797 A2 beschrieben, deren Offenbarungsgehalt hinsichtlich der Dünnfilmbauweise hiermit ausdrücklich durch Rückbezug aufgenommen wird.

Bei den in Verbindung mit den Figuren 1B und 1C beschrieben Ausführungsbeispielen des optoelektronischen Halbleiterchips 1 handelt es sich um Dünnfilmchips. Dabei folgt dem Träger 8 eine reflektierende Schicht oder Schichtenfolge 7 nach, die zur Reflexion von in den Halbleiterchip 1 eintretender oder im Halbleiterchip 1 erzeugter Strahlung vorgesehen ist. Auf der dem Träger abgewandte Seite der Spiegelschicht 7 ist eine Streuschicht 6 angeordnet, welche optional ist und die Streuung der in Richtung der Spiegelschicht 7 tretenden elektromagnetischen Strahlung oder der von der Spiegelschicht 7 reflektierten elektromagnetischen Strahlung ermöglicht. Ferner umfasst der optoelektronische Halbleiterchip eine aktive Zone 4, die zur Strahlungserzeugung vorgesehen ist. Die aktive Zone 4 kann dazu mehrere Halbleiterschichten umfassen. Beispielsweise umfasst die aktive Schicht einen pn-Übergang, eine Heterostruktur, eine Einfachquantentopfstruktur und/oder eine Mehrfachquantentopfstruktur. Die Bezeichnung Quantentopfstruktur umfasst insbesondere auch jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Die aktive Zone 4 ist von Mantelschichten 5 umgeben, die n-beziehungsweise p-dotiert sind. Ferner weist der optoelektronische Halbleiterchip eine zweite Streuschicht 6 auf, die auf die der aktiven Zone 4 abgewandte Oberfläche einer Mantelschicht 5 aufgebracht ist und ebenfalls optional ist. Auch diese Streuschicht 6 dient zur Streuung der in den optoelektronischen Halbleiterchip eintretenden beziehungsweise aus dem optoelektronischen Halbleiterchip durch die Strahlungsdurchtrittsfläche 3 austretenden Strahlung. Auf die Strahlungsdurchtrittsfläche 3 ist eine Kontaktstelle 2 aufgebracht. Beim in Verbindung mit der Figur 1B beschriebenen Ausführungsbeispiel umfasst die Kontaktstelle 2 eine Kontaktmetallisierung 2a, die direkt auf die Strahlungsdurchtrittsfläche 3 aufgebracht ist und beispielsweise aus Gold besteht. Auf die Kontaktmetallisierung 2a ist eine erste reflektierende Schichtenfolge 2b aufgebracht, die vorliegend eine einzige Schicht enthält, die beispielsweise aus Aluminium, Silber oder einer Aluminium-Silber-Legierung besteht. Im Vergleich zur Kontaktmetallisierung 2a weist die erste reflektierende Schichtenfolge 2b eine erhöhte Reflektivität für im optoelektronischen Halbleiterchip 1 erzeugte elektromagnetische Strahlung auf. Weiter ist es möglich, dass die erste reflektierende Schichtenfolge 2b eine erhöhte Reflektivität für außerhalb des Halbleiterchips 1 erzeugte elektromagnetische Strahlung aufweist, beispielsweise für Wellenlängen konvertierte Strahlung.

Beim in Verbindung mit der Figur 1C beschriebenen zweiten Ausführungsbeispiel umfasst die zweite reflektierende Schichtenfolge 2b eine Vielzahl von Schichten 22. Beispielsweise kann es sich bei diesen Schichten um eine Abfolge metallischer Schichten handeln, die abwechselnd aus Aluminium und Silber gebildet sein können. Darüber hinaus ist es möglich, dass beispielsweise die äußerste, der Strahlungsdurchtrittsfläche 3 abgewandte Schicht eine dielektrische Schicht ist, welche zur Passivierung der darunter liegenden, metallischen Schichten dient. Darüber hinaus ist es weiter möglich, dass die zweite reflektierende Schichtenfolge aus einer Abfolge dielektrischer Schichten besteht, die beispielsweise einen Bragg-Spiegel oder einen Bragg-artigen Spiegel bilden.

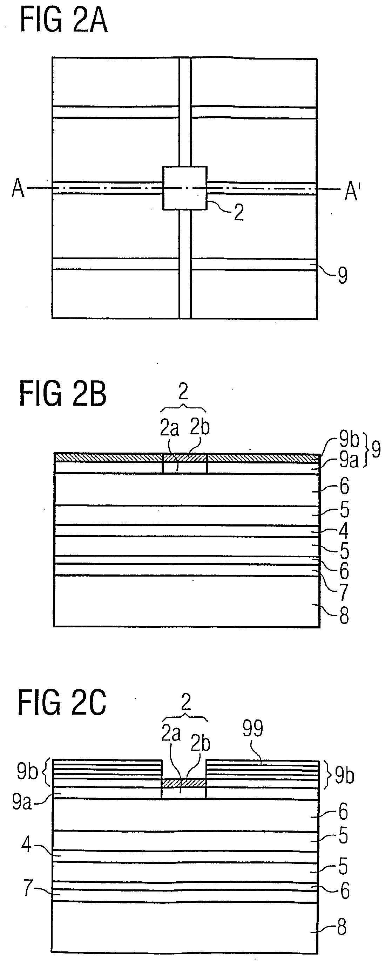

Figur 2A zeigt eine schematische Draufsicht auf einen optoelektronischen Halbleiterchip gemäß einem dritten und vierten Ausführungsbeispiel. Die Figuren 2B und 2C zeigen schematische Schnittdarstellungen entlang der Schnittlinie AA' für das dritte beziehungsweise für das vierte Ausführungsbeispiel des optoelektronischen Halbleiterchips. Bei den in Verbindung mit den Figuren 2A, 2B, 2C beschriebenen Ausführungsbeispielen des optoelektronischen Halbleiterchips sind Stromverteilungsbahnen 9 auf die Strahlungsdurchtrittsfläche aufgebracht. Die Stromverteilungsbahnen 9 sind mit der Kontaktstelle 2 elektrisch leitend verbunden und dienen zu einer gleichmäßigen Verteilung des an der Kontaktstelle 2 eingeprägten elektrischen Stroms über die gesamte Strahlungsdurchtrittsfläche 2. Auf diese Weise ist sichergestellt, dass die aktive Zone 4 gleichmäßig bestromt werden kann.

Beim in Verbindung mit der Figur 2B beschriebenen Ausführungsbeispiel ist die Kontaktstelle 2 durch eine Kontaktmetallisierung 2a sowie eine reflektierende Schichtenfolge 2b gebildet, wie sie auch in Verbindung mit Figur 1B beschrieben sind. Die Stromverteilungsbahnen 9 umfassen jeweils Stromverteilungsmetallisierungen 9a, die beispielsweise aus Gold bestehen, und zweite reflektierende Beschichtungen 9b, die auf die der Strahlungsdurchtrittsfläche 3 abgewandte Oberfläche der Stromverteilungsmetallisierung aufgebracht sind. Diese zweiten reflektierenden Schichtenfolgen 9b können wie die ersten reflektierenden Schichtenfolgen 2b aufgebaut sein, siehe Figur 2B.

Darüber hinaus ist es möglich, wie in Verbindung mit der Figur 2C gezeigt, dass die zweiten reflektierenden Schichtenfolgen 9b anders aufgebaut sind als die ersten reflektierenden Schichtenfolgen 2b. Beispielsweise kann die ersten reflektierenden Schichtenfolge 2b metallisch gebildet sein, während die zweite reflektierende Schichtenfolge 9b ein dielektrisches Material enthalten kann und beispielsweise einen Bragg- oder einen Bragg-artigen Spiegel bildet. Die zweite reflektierende Schichtenfolge 9b weist dann Einzelschichten 99 auf, die aus einem dielektrischen Material bestehen, wobei sich der Brechungsindex einer Einzelschicht 99 von einer benachbarten Einzelschicht unterscheidet.

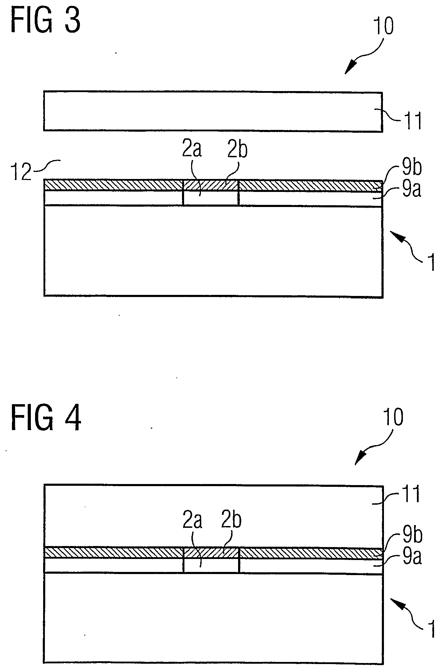

Figur 3 zeigt ein erstes Ausführungsbeispiel eines hier beschriebenen optoelektronischen Halbleiterbauelements 10. Das optoelektronische Halbleiterbauelement 10 umfasst einen optoelektronischen Halbleiterchip 1, wie er beispielsweise in Verbindung mit den Figuren 1A, 1B, 1C, 2A, 2B, 2C beschrieben ist. Ferner umfasst das optoelektronische Halbleiterbauelement ein optisches Filterelement 11. Bei dem optischen Filterelement 11 handelt es sich beispielsweise um ein Polarisationsfilter, ein dichroitisches Filter, ein Lumineszenzkonversionsmaterial, das beispielsweise in einer Schicht vorliegen kann, oder ein Winkelfilter.

Handelt es sich bei dem Filterelement 11 zum Beispiel um ein Polarisationsfilter, so wird elektromagnetische Strahlung, die in der aktiven Zone 4 des optoelektronischen Halbleiterchips 1 erzeugt wird, einer ersten Polarisationsrichtung transmittiert. Die restliche elektromagnetische Strahlung wird vom optischen Filterelement dann zum optoelektronischen Halbleiterchip zurückreflektiert. Dort kann die Strahlung entweder von der Spiegelschicht 7, der Strahlungsdurchtrittsfläche 3 oder der ersten reflektierenden Schichtenfolge 2b beziehungsweise der zweiten reflektierenden Schichtenfolge 9b reflektiert werden.

Bei jedem Reflexionsprozess kann die Polarisationsrichtung verändert werden. Zudem kann die elektromagnetische Strahlung in der aktiven Zone 4 absorbiert und anschließend mit geänderter Polarisationsrichtung reemittiert werden. Die derart reflektierte und reemittierte elektromagnetische Strahlung weist dann einen Polarisationsanteil auf, der vom optischen Filterelement 11 tranmittiert wird. Der Rest der Strahlung erfährt weitere Durchläufe mit den oben beschriebenen Reflexions- oder Absorptionsprozessen.

Handelt es sich bei dem optischen Filterelement 11 um ein dichroitisches Filter, so wird elektromagnetische Strahlung transmittiert, die eine bestimmte Wellenlänge aufweist oder aus einem bestimmten Wellenlängenbereich stammt. Die restliche elektromagnetische Strahlung wird, wie oben beschrieben, vom optischen Filterelement reflektiert und schließlich in der aktiven Zone 4 reabsorbiert und reemittiert.

Handelt es sich bei dem optischen Filterelement 11 um einen Winkelfilter, so wird lediglich elektromagnetische Strahlung transmittiert, die eine Richtung aufweist, die in einem bestimmten Raumwinkelbereich liegt. Insbesondere kann dadurch auf einfache Weise die Leuchtdichte des optoelektronischen Halbleiterbauelements durch Einschränkung des Emissionswinkels auf einen engen Bereich erhöht werden. Nicht transmittierte elektromagnetische Strahlung wird wieder auf den Chip zurückreflektiert und von dort erneut zum optischen Filterelement hin reflektiert. Dabei können mehrere Reflexionen erfolgen, bis die elektromagnetische Strahlung eine Richtung aufweist, in der sie das Winkelfilter passieren kann.

Handelt es sich bei dem optischen Filterelement um ein Lumineszenzkonversionsmaterial, so wird vom Lumineszenzkonversionsmaterial zurück gestreute oder in Richtung der Strahlungsdurchtrittsfläche 3 abgestrahlte konvertierte elektromagnetische Strahlung von der Strahlungsdurchtrittsfläche 3, der ersten reflektierenden Schichtenfolge 2b und / oder der zweiten reflektierenden Schichtenfolge 9b in das Lumineszenzkonversionsmaterial zurückreflektiert. Dort kann es dann transmittiert werden oder nochmals vom Lumineszenzkonversionsmaterial Wellenlängen konvertiert werden.

Beim in Verbindung mit der Figur 3 beschriebenen Ausführungsbeispiel des optoelektronischen Halbleiterbauelements ist ein Spalt 12 zwischen dem optoelektronischen Halbleiterchip 1 und dem optischen Filterelement 11 angeordnet. Dieser Spalt 12 kann beispielsweise mit Luft gefüllt sein.

Beim in Verbindung mit der Figur 4 beschriebenen Ausführungsbeispiel des optoelektronischen Halbleiterbauelements ist das optische Filterelement 11 direkt auf dem optoelektronischen Halbleiterchip 1 angeordnet, sodass sich kein Spalt 12 zwischen optoelektronischem Halbleiterchip und optischem Filterelement befindet.

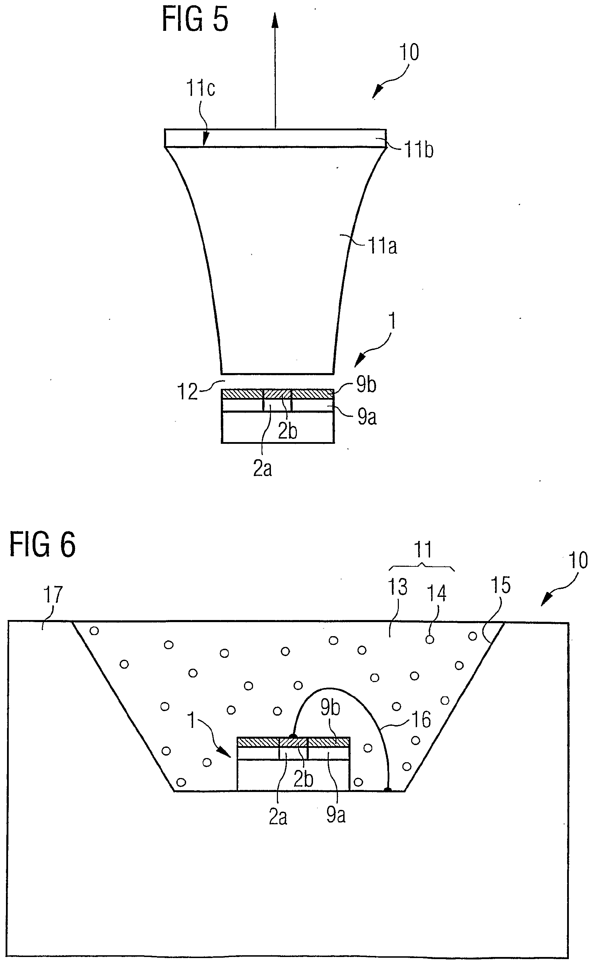

Im Ausführungsbeispiel der Figur 5 umfasst das optische Filterelement 11 einen Optikkörper 11a, der beispielsweise eine reflektierende Optik, wie einen Reflektor und/oder einen optischen Konzentrator, etwa ein CPC (Compound Parabolic Concentrator), ein CHC (Compound Hyperbolic Concentrator) oder CEC (Compound Elliptic Concentrator) umfasst. Auf eine Strahlungsdurchtrittsfläche 11c des Optikkörpers 11a ist dann eine Filterschicht 11b aufgebracht. Die Filterschicht 11b kann wie das in Verbindung mit der Figur 3 beschriebene optoelektronisches Filterelement 11 gebildet sein.

In Verbindung mit der Figur 6 ist ein weiteres Ausführungsbeispiel eines hier beschriebenen optoelektronischen Halbleiterbauelements gezeigt.

In diesem Ausführungsbeispiel ist das optische Filterelement durch Lumineszenzkonversionspartikel 14, die in einer Vergussmasse 13 angeordnet sind, gebildet. Die Vergussmasse 13 mit den Lumineszenzkonversionspartikeln 14 bildet ein Lumineszenzkonversionsmaterial. Darüber hinaus umfasst das Filterelement Reflektorwände 15, die beispielsweise durch schräg gestellte Innenwände eines Gehäuses 17 für den optoelektronischen Halbleiterchip gebildet sind. Elektromagnetische Strahlung, die im Halbleiterchip 1 erzeugt wird, kann von den Reflektorwänden 15 oder den Lumineszenzkonversionspartikeln 14 auf den Halbleiterchip zurückreflektiert werden. Diese Strahlung wird an der Strahlungsdurchtrittsfläche 3, der ersten reflektierenden Schichtenfolge 2b, der zweiten reflektierenden Schichtenfolge 9b oder der Spiegelschicht 7 reflektiert.

In allen hier beschriebenen Ausführungsbeispielen des optoelektronischen Halbleiterbauelements verbessern die ersten und zweiten reflektierenden Schichtenfolgen die Effizienz des Bauelements, da auf die Kontaktstelle 2 beziehungsweise die Stromverteilungsbahnen 9 treffende elektromagnetische Strahlung dort nicht absorbiert wird, sondern zum weiteren Gebrauch reflektiert wird.

## Patentansprüche

1. Optoelektronischer Halbleiterchip (1) umfassend einen Halbleiterkörper mit
- einer Strahlungsdurchtrittsfläche (3), durch welche im Halbleiterchip erzeugte elektromagnetische Strahlung den Halbleiterkörper verlassen kann,
- einer Kontaktmetallisierung (2a), die auf die Strahlungsdurchtrittsfläche (3) aufgebracht ist,
- einer ersten reflektierenden Schichtenfolge (2b), die auf die der Strahlungsdurchtrittsfläche (3) abgewandte Oberfläche der Kontaktmetallisierung (2a) aufgebracht ist, wobei die reflektierende Schichtenfolge (2b) eine höhere Reflektivität als die Kontaktmetallisierung aufweist und zur Reflektion von zur Kontaktmetallisierung (2a) zurückreflektierter elektromagnetischer Strahlung vorgesehen ist, und bei dem
- zumindest eine Stromverteilungsbahn (9) auf die Strahlungsdurchtrittsfläche aufgebracht ist, wobei die Stromverteilungsbahn (9) elektrisch leitend mit der Kontaktmetallisierung (2a) verbunden ist, und
- die Stromverteilungsbahn (8) eine Stromverteilungsmetallisierung (9a) sowie eine zweite reflektierenden Schichtenfolge (9b) aufweist, die auf die der Strahlungsdurchtrittsfläche (3) abgewandte Oberfläche der Stromverteilungsmetallisierung (9a) aufgebracht ist, wobei die zweite reflektierende Schichtenfolge (9b) zur Reflektion von zur Stromverteilungsmetallisierung (9a) zurückreflektierter elektromagnetischer Strahlung vorgesehen ist.

2. Optoelektronischer Halbleiterchip nach dem vorherigen Anspruch,
bei dem die erste reflektierende Schichtenfolge (2b) zumindest eine Schicht umfasst, die ein Metall enthält.

3. Optoelektronischer Halbleiterchip nach zumindest einem der vorherigen Ansprüche,
bei dem die erste reflektierende Schichtenfolge (2b) zumindest eine Schicht (22) umfasst, die zumindest eines der folgenden Metalle enthält: Aluminium, Silber.

4. Optoelektronischer Halbleiterchip nach zumindest einem der vorherigen Ansprüche,
bei dem die erste reflektierende Schichtenfolge (2b) zumindest eine Schicht (22) umfasst, die ein dielektrisches Material enthält.

5. Optoelektronischer Halbleiterchip nach zumindest einem der vorherigen Ansprüche,
bei dem die erste reflektierende Schichtenfolge (2b) einen Bragg-Spiegel bildet.

6. Optoelektronischer Halbleiterchip nach zumindest einem der vorherigen Ansprüche,
bei dem die zweite reflektierende Schichtenfolge (9b) zumindest eine Schicht umfasst, die ein Metall, insbesondere Aluminium und/oder Silber enthält.

7. Optoelektronischer Halbleiterchip nach zumindest einem der vorherigen Ansprüche,
bei dem die zweite reflektierende Schichtenfolge (9b) zumindest eine Schicht (99) umfasst, die ein dielektrisches Material enthält.

8. Optoelektronischer Halbleiterchip nach zumindest einem der vorherigen Ansprüche,
bei dem die zweite reflektierende Schichtenfolge (9b) einen Bragg-Spiegel bildet.

9. Optoelektronisches Halbleiterbauelement mit
- einem optoelektronischen Halbleiterchip (1) nach zumindest einem der vorherigen Ansprüche, und
- einem dem optoelektronischen Halbleiterchip (1) in einer Abstrahlrichtung nachgeordnetem optischen Filterelement (11), welches geeignet ist, einen ersten Strahlungsanteil mit einer ersten Strahlungseigenschaft zu transmittieren und einen zweiten Strahlungsanteil mit einer zweiten, von der ersten verschiedenen, Strahlungseigenschaft zu reflektieren.

10. Optoelektronisches Halbleiterbauelement nach dem vorherigen Anspruch,
bei dem das optische Filterelement (11) ein dichroitisches Filter umfasst.

11. Optoelektronisches Halbleiterbauelement nach den Ansprüchen 9 oder 10,
bei dem das optische Filterelement (11) einen Polarisationsfilter umfasst.

12. Optoelektronisches Halbleiterbauelement nach einem der Ansprüche 9 bis 11,
bei dem das optische Filterelement (11) ein Winkelfilter umfasst.

13. Optoelektronisches Halbleiterbauelement nach einem der Ansprüche 9 bis 12,
bei dem das optische Filterelement (11) ein Lumineszenzkonversionsmaterial umfasst.

## Claims

1. Optoelectronic semiconductor chip (1) comprising
- a radiation passage area (3), through which electromagnetic radiation generated in the semiconductor chip can leave the semiconductor body,
- a contact metallization (2a) applied to the radiation passage area (3),
- a first reflective layer sequence (2b) applied to that surface of the contact metallization (2a) which is remote from the radiation passage area (3), wherein the reflective layer sequence (2b) has a higher reflectivity than the contact metallization and is provided for reflecting electromagnetic radiation reflected back to the contact metallization (2a), and wherein
- at least one current spreading track (9) is applied to the radiation passage area, wherein the current spreading track (9) is electrically conductively connected to the contact metallization (2a), and
- the current spreading track (8) has a current spreading metallization (9a) and also a second reflective layer sequence (9b) applied to that surface of the current spreading metallization (9a) which is remote from the radiation passage area (3), wherein the second reflective layer sequence (9b) is provided for reflecting electromagnetic radiation reflected back to the current spreading metallization (9a).

2. Optoelectronic semiconductor chip according to the preceding claim,
wherein the first reflective layer sequence (2b) comprises at least one layer which contains a metal.

3. Optoelectronic semiconductor chip according to at least one of the preceding claims,
wherein the first reflective layer sequence (2b) comprises at least one layer (22) which contains at least one of the following metals: aluminum, silver.

4. Optoelectronic semiconductor chip according to at least one of the preceding claims,
wherein the first reflective layer sequence (2b) comprises at least one layer (22) which contains a dielectric material.

5. Optoelectronic semiconductor chip according to at least one of the preceding claims,
wherein the first reflective layer sequence (2b) forms a Bragg mirror.

6. Optoelectronic semiconductor chip according to at least one of the preceding claims,
wherein the second reflective layer sequence (9b) comprises at least one layer which contains a metal, in particular aluminum and/or silver.

7. Optoelectronic semiconductor chip according to at least one of the preceding claims,
wherein the second reflective layer sequence (9b) comprises at least one layer (99) which contains a dielectric material.

8. Optoelectronic semiconductor chip according to at least one of the preceding claims,
wherein the second reflective layer sequence (9b) forms a Bragg mirror.

9. Optoelectronic semiconductor component comprising
- an optoelectronic semiconductor chip (1) according to at least one of the preceding claims
- an optical filter element (11) disposed downstream of the optoelectronic semiconductor chip (1) in an emission direction, wherein the optical filter element is suitable for transmitting a first radiation component having a first radiation property and for reflecting a second radiation component having a second radiation property, which differs from the first radiation property.

10. Optoelectronic semiconductor component according to the preceding claim,
wherein the optical filter element (11) comprises a dichroic filter.

11. Optoelectronic semiconductor component according to the preceding claims 9 or 10,
wherein the optical filter element (11) comprises a polarization filter.

12. Optoelectronic semiconductor component according to at least one of the preceding claims 9 to 11,
wherein the optical filter element (11) comprises an angle filter.

13. Optoelectronic semiconductor component according to at least one of the preceding claims 9 to 12,
wherein the optical filter element (11) comprises a luminescence conversion material.

## Revendications

1. Puce à semi-conducteurs optoélectronique (1) comprenant un corps semi-conducteur avec
- une surface de passage de rayonnement (3) à travers laquelle le rayonnement électromagnétique généré dans la puce à semi-conducteurs peut sortir du corps semi-conducteur,
- une métallisation de contact (2a) appliquée sur la surface de passage de rayonnement (3),
- une première succession de couches réfléchissantes (2b) appliquée sur la surface de la métallisation de contact (2a) détournée de la surface de passage de rayonnement (3), la succession de couches réfléchissantes (2b) présentant une réflectivité supérieure à celle de la métallisation de contact et étant prévue pour la réflexion du rayonnement électromagnétique renvoyé vers la métallisation de contact (2a), et où
- au moins une bande de distribution du courant électrique (9) est appliquée sur la surface de passage de rayonnement, la bande de distribution du courant électrique (9) étant raccordée de manière électroconductrice à la métallisation de contact (2a), et
- la bande de distribution du courant électrique (8) présente une métallisation de distribution du courant (9a) ainsi qu'une deuxième succession de couches réfléchissantes (9b) appliquée sur la surface de la métallisation de contact (9a) détournée de la surface de passage de rayonnement (3), la deuxième succession de couches réfléchissantes (9b) étant prévue pour la réflexion du rayonnement électromagnétique renvoyé vers la métallisation de contact (9a).

2. Puce à semi-conducteurs optoélectronique selon la revendication précédente,
dans laquelle la première succession de couches réfléchissantes (2b) comprend au moins une couche qui contient un métal.

3. Puce à semi-conducteurs optoélectronique selon au moins l'une quelconque des revendications précédentes,
dans laquelle la première succession de couches réfléchissantes (2b) comprend au moins une couche (22) qui contient au moins un des métaux suivants : de l'aluminium, de l'argent.

4. Puce à semi-conducteurs optoélectronique selon au moins l'une quelconque des revendications précédentes,
dans laquelle la première succession de couches réfléchissantes (2b) comprend au moins une couche (22) qui contient un matériau diélectrique.

5. Puce à semi-conducteurs optoélectronique selon au moins l'une quelconque des revendications précédentes,
dans laquelle la première succession de couches réfléchissantes (2b) forme un miroir de Bragg.

6. Puce à semi-conducteurs optoélectronique selon au moins l'une quelconque des revendications précédentes,
dans laquelle la deuxième succession de couches réfléchissantes (9b) comprend au moins une couche qui contient un métal, notamment de l'aluminium et/ou de l'argent.

7. Puce à semi-conducteurs optoélectronique selon au moins l'une quelconque des revendications précédentes,
dans laquelle la deuxième succession de couches réfléchissantes (9b) comprend au moins une couche (99) qui contient un matériau diélectrique.

8. Puce à semi-conducteurs optoélectronique selon au moins l'une quelconque des revendications précédentes,
dans laquelle la deuxième succession de couches réfléchissantes (9b) forme un miroir de Bragg.

9. Composant à semi-conducteurs optoélectronique avec
- une puce à semi-conducteurs optoélectronique (1) selon au moins l'une quelconque des revendications précédentes, et
- un élément de filtre (11) disposé, dans une direction de rayonnement, en aval de la puce à semi-conducteurs optoélectronique (1) qui est propre à transmettre une première part du rayonnement possédant une première propriété de rayonnement et à refléter une deuxième part du rayonnement possédant une deuxième propriété de rayonnement qui est différente de la première propriété de rayonnement.

10. Composant à semi-conducteurs optoélectronique selon la revendication précédente,
dans laquelle l'élément de filtre optique (11) comporte un filtre dichroïque.

11. Composant à semi-conducteurs optoélectronique selon la revendication 9 ou 10,
dans laquelle l'élément de filtre optique (11) comporte un filtre polarisant.

12. Composant à semi-conducteurs optoélectronique selon l'une quelconque des revendications 9 à 11,
dans laquelle l'élément de filtre optique (11) comporte un filtre d'angle.

13. Composant à semi-conducteurs optoélectronique selon l'une quelconque des revendications 9 à 12,
dans laquelle l'élément de filtre optique (11) comporte un matériau de conversion de luminescence.
